# EUROPEAN PATENT APPLICATION

(11) **EP 0 865 089 A2**
(43) Date of publication of application: **16.09.1998**
(21) Application number: 98301806.0
(22) Date of filing: 11.03.1998
(51) Int. Cl.: H01L 51/20

(54) **Production process for organic electroluminescent light emitting devices**

(30) Priority: 11.03.1997 JP 74553/97
(71) Applicant: TDK Corporation, Chuo-ku, Tokyo (JP)
(72) Inventor: Nakaya, Kenji, Chuo-ku, Tokyo (JP); Kobori, Isamu, Chuo-ku, Tokyo (JP); Tanabe, Hiroshi, Chuo-ku, Tokyo (JP)
(74) Representative: Feakins, Graham Allan

(57) **Abstract**

A sputtering system with opposite targets is provided, which comprises a pair of targets positioned in parallel opposition to each other with a given space located therebetween, magnetic field generating means for generating a magnetic field in a substantially vertical direction with respect to surfaces of the targets, and shield means located at such positions as to cover portions of the targets except opposite surfaces thereof. A substrate is positioned in opposition to the space between said targets. A given voltage is applied between the targets and the shield means, so that an electrode is provided on an organic EL structure formed on the substrate by sputtering.

## Description

### BACKGROUND OF THE INVENTION

The present invention relates generally to an organic electroluminescent light emitting device (which will hereinafter be often called an organic EL device for short) using an organic compound and a production process for this organic EL device, and more particularly to a process of forming an electrode film that causes less damage to an organic layer.

In recent years, organic EL light emitting devices have been under intensive investigation. One typical light emitting device includes a glass substrate and a transparent electrode or anode of tin-doped indium oxide (ITO) or the like formed on the substrate. A thin film serving as a hole transporting layer is formed on the anode by evaporating a hole transporting material such as triphenyldiamine (TPD). A light emitting layer of a fluorescent material such as an aluminum quinolinol complex (Alq³) is deposited on the hole transporting layer. An electrode or cathode is formed thereon from a metal having a low work function such as magnesium. Such organic EL devices attract attentions because they can achieve a very high luminance ranging from 100 to 10,000 cd/m² with a driving voltage of approximately 10 volts.

The cathode of such organic EL devices is generally made up of a material capable of injecting more electrons into the light emitting layer. In other words, the lower the work function of a material, the more suitable is the material as a cathode. Various materials having a low work function are available. For instance, the materials which are used as the cathodes of organic EL devices generally include MgAg disclosed in JP-A 2-15595, and a metal material such as AlLi disclosed in JP-A 5-121172. The reason is that the production process for organic EL devices relies chiefly upon evaporation making use of resistance heating, and so the evaporation source used therewith is as a matter of course limited to one having a high vapor pressure at low temperatures.

However, a film form of cathode produced by a vacuum evaporation technique making use of resistance heating is found to have several problems such as poor adhesion to an organic layer interface, low light emission efficiency, and non-light emitting spots called dark spots which are formed on pixels by the delamination of the electrode just after production. The dark spots become large as the device is driven, and so become a leading factor that governs the service life of the device, the quality of what is displayed on the device, etc.

An evaporation source comprising a material having a low work function is usually formed thereon with an oxide layer, because the material is of high reactivity with respect to oxygen or moisture, and is usually handled in the atmosphere for feeding, and supply purposes. When such a material is used for the formation of a cathode, it is desired to carry out evaporation after removal of the oxide layer from the surface of the material. However, this is difficult because, in a rare case alone, the oxide has a lower evaporation temperature or a higher vapor pressure than does a pure metal. It is thus difficult to form a cathode consisting of a pure metal film. When an oxide is formed at an interface between the electrode and the organic layer or in the electrode, the resulting work function and electrical conductivity deviate from those of the pure metal. This renders it impossible to obtain any desired EL properties.

The sole use of Mg or Li as a cathode is not preferable in view of film-forming capability, adhesion, and oxidation resistance, and so alloys such as MgAg, MgIn, and AlLi are usually used. Because the alloy metal components have often varying vapor pressures, it is general to rely on a double evaporation technique. A problem with this double evaporation technique is, however, that it is difficult to obtain the optimum mixing ratio in a stable manner for each batch; it is difficult to keep the composition of the resulting alloy thin film invariable.

From a practical perspective, too, this double evaporation technique has various productivity problems among which: (1) it is required to make a material replacement or addition within a short time of period, (2) a film having a large area is inconsistent in terms of thickness and quality, and (3) consistent film quality and reproducibility are not obtained at an increased film forming rate.

One of possible vacuum film forming techniques is a sputtering technique. A cathode film prepared by such a process as set forth in JP-A 4-19936 or 8-250284 is improved in terms of its adhesion to an interface with an organic layer, because the atoms or atom groups to be sputtered have a kinetic energy higher than would be possible with the evaporation technique and so achieve large surface migration. By performing pre-sputtering prior to this process a surface oxide layer can be removed in vacuum or by performing reverse sputtering moisture or oxygen adsorbed onto an organic layer interface can be eliminated, so that a clean electrode-organic layer interface or a clean electrode can be formed. This makes it possible to obtain stable organic EL devices.

Even with a sputtering process wherein a mixture of materials having largely varying vapor pressures is used as a target, the composition of the film to be formed dose not largely deviate from the composition of the target. Thus, the sputtering technique is not limited by the vapor pressures of the materials used, unlike the evaporation technique. Besides, the sputtering technique is advantageous over the evaporation technique in terms of productivity because it is unnecessary to feed the materials over an extended period of time, and the resulting film is improved in terms of the consistency of thickness and quality as well.

However, a conventional sputtering process such as a magnetron sputtering process is carried out at a gas pressure of 0.3 to 1.0 Pa using an inert gas such as an argon gas. The atoms or atom groups to be sputtered have a kinetic energy higher than would be obtained with the evaporation technique by a factor of several dozens to several hundreds. When film forming sputtering is applied directly to an organic EL structure formed of an organic material, therefore, no sufficient homogeneity of film composition is obtained because secondary electrons or sputtering particles having a high kinetic energy cause damage to the organic EL structure. More specifically, many ionized electrons or ionized sputtering particles cause physical destruction of the organic EL structure upon collision therewith, resulting in a drop of the electrostatic breakdown voltage of the organic EL device. Upon the application of a voltage between the cathode and the anode, the device structure breaks down due to leakage or a temperature rise. As a result, the organic EL device may possibly lose its own function. Otherwise, there may be an increase in the driving voltage or a luminance drop, leading to degradation of the EL properties. In addition, the potential of the substrate may be constantly reduced to about minus several dozen bolts by self-biasing, resulting in re-sputtering due to sputtering gas (Ar) ions and, hence, a composition deviation.

As already mentioned, the material having a low work function is used as a cathode material in view of electron injection efficiency. However, this material is of high reactivity with respect to oxygen or moisture, and is very unstable. From a reliability perspective, therefore, it is desired to cover a stable film, e.g., a nitride or oxide film over a cathode just after its preparation for sealing purposes. However, the magnetron sputtering process is carried out using an insulator target with an RF power source or alternatively an electrically conductive target with the introduction of a reactive gas such as nitrogen or oxygen therein. Thus, this process is poor in productivity due to a slow film forming rate, and may possibly give rise to an increase in the temperature of the substrate due to radiation as well.

A process of introducing a similar reactive gas in an electrically conductive target using a DC power source is also available. However, the entrainment of nitrogen in an argon gas prevailing all over the target results in the nitriding or oxidation of the surface of the target. This, in turn, causes a high-resistance film or insulator to be deposited on a non-erosion area, resulting in abnormal discharge due to arcs, film defects, or disturbed film formation due to the consumption of input power by arcs. On the other hand, a problem with the use of an arc-preventing adapter is that productivity becomes worse due to a low film forming rate.

An object of the invention is to achieve a production process for organic EL devices, which improves the adhesion of an electrode to an organic layer at an interface therebetween, enables an organic EL device having an extended service life and presenting high-quality displays to be produced, and causes little or no physical damage to films that forms an organic EL device.

### SUMMARY OF THE INVENTION

According to the present invention, such an object is achievable by the inventions recited below as (1) to (3).
(1) A process for producing an organic electroluminescent light emitting device by providing a sputtering system with opposite targets, which comprises a pair of targets positioned in parallel opposition to each other with a given space located therebetween, magnetic field generating means for generating a magnetic field in a substantially vertical direction with respect to surfaces of said targets, and shield means located at such positions as to cover portions of said targets except opposite surfaces thereof, with a substrate positioned in opposition to said space between said targets, and applying a given voltage between said targets and said shield means, so that an electrode is provided on an organic electroluminescent light emitting structure formed on said substrate by a sputtering technique.
(2) A production process for an organic EL device, wherein a cathode is formed by the sputtering technique recited in (1), and sputtering is then carried out by introducing a reactive gas to form a protective film on said cathode.
(3) The production process of (2), wherein a sputtering gas is fed from the vicinity of the target that is not opposite to said substrate while said reactive gas is fed from the vicinity of a surface of said substrate on which a film is formed.

According to the production process of the invention, it is possible to obtain organic EL devices having a high initial light emission luminance and an extended half-life of luminance. Initial dark spots are considerably reduced, and the appearance and growth of dark spots after driving are substantially inhibited as well. A grave problem with the vacuum evaporation technique is the appearance, and growth of dark spots. According to the invention, this problem is substantially resolved, resulting in considerable improvements in light emission properties (longer service life and high-quality displays). This appears to be because, according to the invention, the adhesion of the electrode to the organic layer at the interface between them is improved due to less physical damage to the films forming the organic EL device, so that uniform yet well adhesive films can be formed.

### BRIEF DESCRIPTION OF THE DRAWINGS

The above and other objects, features, and advantages of the present invention will be better understood from the following description taken in conjunction with the accompanying drawings, in which:

Figure 1 is a general view illustrating one basic embodiment of the sputtering system with opposite targets used in the invention.

Figure 2 is a general view illustrating one basic embodiment wherein the sputtering system with opposite targets used in the invention is used as a reactive sputtering system.

Figure 3 is a general view showing one typical embodiment of increasing the film forming rate of the sputtering system with opposite targets used in the invention.

Figure 4 is a schematic representation of one embodiment of the organic EL device of the invention.

Figure 5 is a schematic representation of another embodiment (inverted multilayer structure) of the organic EL device of the invention.

### DETAILED DESCRIPTION OF PREFERRED EMBODIMENTS OF THE INVENTION

Some preferred embodiments of the invention will now be explained at great length.

According to the invention, an organic EL device is produced by providing a sputtering system with opposite targets, which comprises a pair of targets positioned in parallel opposition to each other with a given space located therebetween, magnetic field generating means for generating a magnetic field in a substantially vertical direction with respect to surfaces of said targets, and shield means located at such positions as to cover portions of said targets except opposite surfaces thereof, with a substrate positioned in opposition to said space between said targets, and applying a given voltage between said targets and said shield means, so that an electrode is provided on an organic EL structure formed on said substrate by a sputtering technique.

According to the invention, sputtering is carried out by generating a plasma between the opposite targets in the sputtering system. Using secondary electrons emitted from the targets, the ionization of the gas is accelerated to generate a high density plasma. This plasma is held by a magnetic field generated from the magnetic field generating means and applied on a sputtering surface in a vertical direction thereto or on an electric field in a parallel direction thereto. Thus, a plasma generation area is completely separated from a film forming area where a film is formed in a plasma-free-like state. Since a substrate is hardly exposed to the plasma, the film can be formed while a filter substrate, an organic layer on the organic EL structure and a film deposited thereon are not damaged by high energy particles. It is thus possible to prevent destruction of the device structure due to leakage ascribed to an electrostatic breakdown voltage drop or temperature rises. Further, degradation of the EL properties such as a driving voltage increase or a luminance drop can be substantially averted. Furthermore, any film composition deviation is substantially avoided because no self-bias is applied on the substrate and, hence, re-sputtering by sputtering gas ions is most unlikely to occur. In the magnetron sputtering process, a doughnut-like area with a high density plasma is formed. Since this area is limited, however, a target is susceptible to undergo a local erosion with a composition deviation. It is thus impossible to keep film forming conditions invariable. This composition deviation becomes large with the progress of erosion, resulting in a target efficiency drop. This is in sharp contrast to the sputtering process with opposite targets wherein the high density plasma is distributed over an area substantially as wide as the target area, so that consistent film forming conditions can be achieved with an increased target efficiency. According to the sputtering process with opposite targets, it is thus possible to form an intimate film in a stress-free or stress-free-like state with a reduced composition deviation.

In what follows, specific embodiments of the sputtering system with opposite targets used in the invention will be explained with reference to the accompanying drawings.

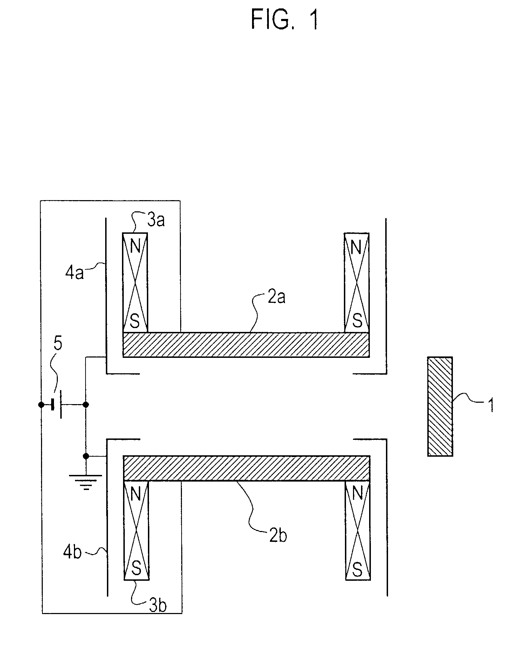

Fig. 1 is a general view of one specific embodiment of the sputtering system with opposite targets used in the invention. As shown therein, the sputtering system with opposite targets comprises a substrate 1, a pair of targets 2a and 2b, magnetic field generating means 3a and 3b, shields 4a and 4b, and a power source 5.

Targets 2a and 2b are placed in a vacuum chamber (not shown) while they are opposite to each other and are positioned substantially parallel to each other at a suitable interval. The targets may be each made up of the same material as that of which the cathode, anode and protective film provided on an organic EL device structure are formed or a material providing the cathode, anode and protective film by reaction with a reactive gas. Target shape may be appropriately determined depending on the shape, and size of the substrate used. While the target may be in a rectangular or circular shape, it is preferable that the target takes a rectangular shape that is extended in the longitudinal direction (in the vertical direction with respect to the drawing sheet). Target size, albeit being not critical, is usually of the order of 10 to 500 x 10 to 500 mm. Targets 2a and 2b may be made up of an identical or different materials. When the targets used are made up of different materials, film composition control may be achieved by controlling individual voltages to be applied on the targets.

Magnetic field generating means 3a and 3b may be made up of permanent magnets or electromagnets provided that they can generate magnetic fields in a vertical direction with respect to the surfaces of the targets at a flux density of given strength. From an economic perspective, preference is given to the permanent magnets. In the instant embodiment, magnetic field generating means 3a and 3b are positioned on the back sides of targets 2a and 2b. However, they may be located at such positions that the density of the plasma generated can be uniformized, thereby preventing the generation of local arcs on the surfaces of the targets. The strength of the magnetic filed generated is preferably of the order of 50 to 2,000 Oe, and more preferably of the order of 200 to 1,000 Oe as measured on each target. The permanent magnets used herein, for instance, may be Fe-Nd-B, Sm-Co, ferrite, and alnico magnets. The permanent magnets used herein are usually in a square block shape although not particularly limited thereto. Magnetic field generating means 3a and 3b may be located at positions other than those illustrated on condition that they can generate predetermined magnetic fields on the targets. If the ability of means 3a and 3b to be accommodated in the vacuum chamber as well as economic considerations are taken into account, however, it is preferable to locate them on the back sides of the targets. The magnetic field generating means may be located everywhere on the back sides of the targets if they can generate predetermined magnetic fields. Preferably but not exclusively, however, they are located at the ends of the back sides of the targets. In the illustrated embodiment, one target 2a serves as an N pole while the other target 2b serves as an S pole. However, this may be reversed.

Power source 5 is provided to apply given voltages between targets 2a and 2b and shields 4a and 4b for DC sputtering. With the targets serving as cathodes, the applied voltages are of the order of 300 to 1,200 V, and preferably of the order of 500 to 1,000 V.

Substrate 1 is provided thereon with a film form of organic EL device, and positioned in opposition to the aforesaid space between targets 2a and 2b. For the substrate, an appropriate selection may be made from known substrate materials used for sputtering equipment. Such a substrate, for instance, may be made up of insulating substrate materials such as ceramic materials represented by glass or alumina, with the glass being particularly preferred. It is noted that an electrically conductive substrate may be used with no charging-up phenomenon. It is preferable to insulate the conductive substrate as in the case of a conductive metal substrate provided with SiO₂ or other insulator on its back side, because the advantages of the invention then become more noticeable. The substrate may be in a rectangular or disk plate form although not particularly limited thereto. Substrate size is not critical, and so may be in the range of about 5 to 500 mm x 5 to 500 mm for a rectangular form, for instance. Substrate 1 may be used alone or in combination with like other substrate or substrates. When a plurality of such substrates are used, it is preferable that they are located on a circumference with respect to the targets. Most of sputtering particles are scattered from the surfaces of the targets with certain angles (of the order of -50° to +50° with respect to the surfaces of the targets). It is thus preferable to direct the surface of the substrate toward the scattering direction of the sputtering particles. With a plurality of substrates used, it is also preferable to associate them with a pair of targets 2a and 2b, respectively. Alternatively, it is preferable to incline center axes vertical to the surfaces of the substrates at an angle of ±20° to 50° with respect to a direction parallel to targets 2a and 2b.

Shields 4a and 4b are positioned in such a way that they cover portions of targets 2a and 2b except their opposite surfaces, and magnetic field generating means 3a and 3b as well in the instant embodiment. In the DC sputtering process shown, the shields serve as electrodes to be grounded. More exactly, in the DC sputtering process preferably used in the invention the aforesaid voltages are applied from power source 5 between cathodes defined by targets 2a and 2b and anodes defined by shields 4a and 4b. While RF sputtering using power source 5 as a radio-frequency source may be carried out in the invention, it is preferable to rely on the DC sputtering process because of less damage to the organic EL device structure and ease with which film formation is controlled.

Specific dimensional relations among the parts are explained. The position of substrate 1 is determined by the plasma forming area, and the film forming rate as well. Substrate 1 must be located at a position where a plasma-free or plasma-free-like state is obtainable; however, when it is spaced too far away from targets 2a and 2b, the film forming rate drops. It is thus preferable to space the substrate 10 to 100 mm, especially 20 to 100 mm, away from the ends of targets 2a and 2b. The spacing between one target 2a and the other target 2b is preferably in the range of 100 to 300 mm, and especially 150 to 250 mm.

Referring here to the conditions for operating such a sputtering system, the pressure of the sputtering gas during sputtering is preferably of the order of 10⁻⁴ to 10¹ Pa and especially of the order of 10⁻³ to 10⁻¹ Pa, and the input power during sputtering is preferably in the range of 1 to 100 W/cm².

For the sputtering gas, inert gases used with ordinary sputtering equipment, for instance, Ar, He, Ne, Kr, and Xe are used. For the reactive sputtering process, it is possible to use, in addition to such inert gases, sputtering gases such as N₂, O₂, H₂O, N₂O, NOₓ, NH₃, C₂H₂, CH₄, C₂H₄, CO, H₂, and H₂S. The flow ratio between the sputtering gas and the reactive gas may be arbitrarily determined, and the flow rate of the sputtering gas, and reactive gas during sputtering may be of the order of 1 to 30 sccm although not particularly limited thereto.

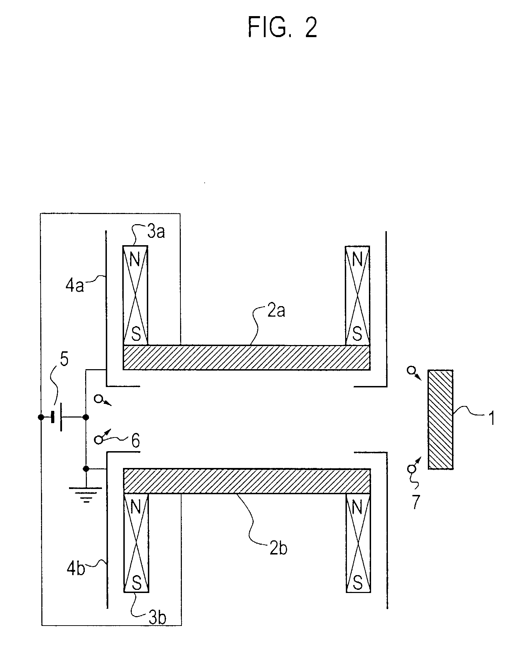

Fig. 2 is a schematic view of another embodiment of the sputtering system with opposite targets used for reactive sputtering according to the invention. In the instant embodiment, sputtering gas-feeding ports 6 and reactive gas-feeding ports 7 are added to the embodiment shown in Fig. 1. As illustrated, a pair of sputtering gas-feeding ports 6 are provided in the vicinity of the sides of targets 2a and 2b that are not opposite to substrate 1 while a pair of reactive gas-feeding ports 7 are provided in the vicinity of substrate 1. Gas feeding lines are not shown for the purpose of simplicity. Arrows represent the feeding directions of the respective gases.

Such an arrangement enables the reactive gas fed to the vicinity of the substrate to be carried along the substrate, so that the reactive gas can be efficiently consumed. Also, it is less likely that the reactive gas is mixed with the sputtering gas in the vicinity of the targets because the place to which the reactive gas is fed is far from the place to which the sputtering gas is fed. The means for introducing the reactive gas in the sputtering system is not limited to that shown in Fig. 2. For instance, it is possible to feed the sputtering gas and reactive gas via a common feeding means. In this case, however, it is noted that the reaction efficiency drops.

In the practice of the invention, a bias voltage may be applied on the substrate. With the sputtering system with opposite targets according to the invention, elaborate voltage control is so feasible that film quality control can be easily achieved, because the substrate is located at a plasma-free or plasma-free-like position. This is in sharp contrast to the magnetron sputtering process wherein no minute bias voltage can be applied to the substrate because a self-bias voltage of the order of minus several dozen volts is applied to the substrate from the first.

According to the invention, it is also possible to introduce microwaves in the plasma maintained between the targets to heat primarily electrons, thereby accelerating ionization. This, in turn, enables the density of plasma generated to be so high that the film forming rate can be improved.

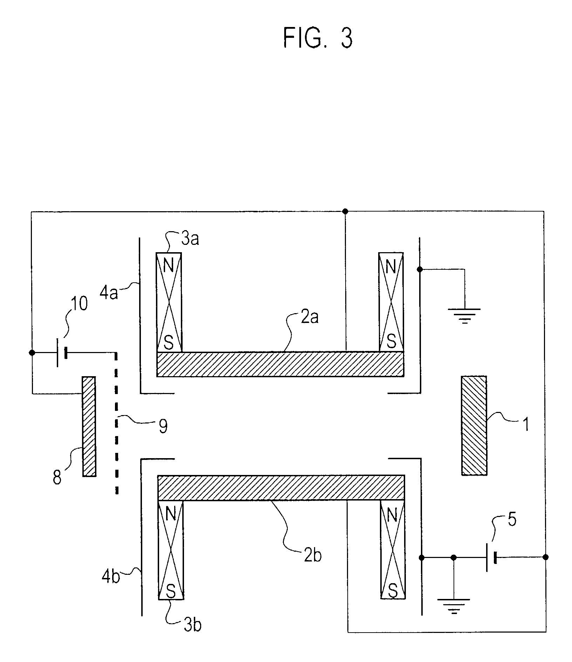

Another approach to improving the film forming rate is to provide an auxiliary target 8 at a position opposite to substrate 1, as typically shown in Fig. 3. In other words, auxiliary target 8, a grid electrode 9 and an auxiliary power source 10 are added to the embodiment shown in Fig. 1. Auxiliary target 8 is positioned in opposition to substrate 1 through the space between targets 2a and 2b. Auxiliary target 8 may be made up of the same material as that of which each target 2a or 2b is formed or the material constituting the aforesaid electrodes, etc.

In addition to the voltage from power source 5, a further about 300 to 500 V is applied on grid electrode 9 via auxiliary power source 10. Applied on auxiliary target 8 via power source 5 is the same voltage as that on target 2a, and 2b. The distance between auxiliary target 8 and grid electrode 9 may be equal to or shorter than the average free path of neutral gas molecules at the sputtering gas pressure, and the grid electrode may have a mesh size enough to ensure an area transmittance of at least 90%.

Sputtering particles flying out of targets 2a and 2b sputter auxiliary target 8, and are then again scattered from auxiliary target 8 together with sputtering particles therefrom for deposition on substrate 1. Thus, the sputtering particles that do not propagate toward substrate 1, too, can be effectively utilized so that the film forming rate can be improved.

To prevent the plasma formed from expanding toward the substrate, it is preferable to provide a shield cover or chip capable of absorbing plasma to lower its density.

In the practice of the invention, electrodes are formed of suitable materials by such a sputtering process. To achieve effective electron injection, the cathode is preferably made up of a material having a low work function, for instance, any one of metal elements such as K, Li, Na, Mg, La, Ce, Ca, Sr, Ba, Al, Ag, In, Sn, Zn, and Zr. To improve the stability of the cathode, it is preferably made up of a binary or ternary alloy system comprising two or three of the aforesaid metal elements. Preferable for such an alloy system, for instance, are Mg·Ag (Ag: 1 to 20 at%), Mg·In (In: 1 to 50 at%), Al·Ca (Ca: 1 to 20 at%), and Al·In (In: 1 to 10 at%). Thus, the sputtering targets are usually made up of such cathode-forming metals or alloys.

The cathode thin film may have at least a thickness large enough to achieve satisfactory electron injection, for instance, of at least 0.1 nm. While there is no upper limit to film thickness, a film thickness of the order of 0.1 to 500 nm is usually preferred.

The sputtering process of the invention may also be used to obtain an anode. The material and thickness of this anode are preferably determined such that at least 70% of light emission is transmitted by the anode. More illustratively, materials such as tin-doped indium oxide (ITO), zinc-doped indium oxide (IZO), ZnO, SnO₂, and In₂O₃ are preferably used for the anode. Anode thickness is preferably of the order of 10 to 500 nm. To improve the reliability of the device, the driving voltage must be low. From this perspective, ITOs of 10 to 30 Ω/□ (film thickness: 50 to 300 nm) are preferable. In actual applications, the thickness and optical constant of the anode may be determined such that the efficiency of taking out light emission and color purity are well satisfied by the interference effect due to reflection at an interface of the anode of ITO or the like.

Preferably, a large device such as a display device is interconnected with aluminum or other metal because the resistance of an anode of ITO or the like is increased, resulting in a voltage drop.

Preferably, the organic EL device of the invention is provided thereon with a protective layer using such reactive sputtering as mentioned above. Preferably in this case, the protective layer is formed of the cathode forming material, i.e., at least one of oxides, nitrides and carbides of metal and alloy materials having a work function of up to 4 eV. It is here noted that the raw material for the protective film has usually the same composition as that of the cathode material although it may have somewhat different compositions or it may be free of one or more components of the cathode forming material. By forming the protective layer of the same material as the cathode forming material, it is thus possible to form the protective layer subsequent to the formation of the cathode.

The oxygen content of such oxides, the nitrogen content of such nitrides, and the carbon content of such carbides may deviate from the respective stoichiometric composition values; they may be 0.5 to 2 times as large as such values.

Preferably, the same material as the cathode material is used for the targets; O₂, CO or the like is used as the reactive gas for oxide formation; N₂, NH₃, NO, NO₂, N₂O or the like is used as the reactive gas for nitride formation; and CH₄, C₂H₂, C₂H₄ or the like is used as the reactive gas for carbide formation. These reactive gases may be used alone or in combination of two or more.

The protective film may have a certain or larger thickness enough to ensure prevention of penetration of moisture, oxygen or organic solvents, and so may have a thickness in the range of preferably at least 50 nm, more preferably at least 100 nm, and most preferably 100 to 1,000 nm.

The total thickness of the cathode plus the protective film is usually of the order of 100 to 1,000 nm although not particularly limited thereto.

By the provision of such a protective film, it is possible to prevent oxidation, etc. of the cathode and, hence, drive the organic EL device in a stable manner over an extended period of time.

The organic light emitting device produced by the process of the invention may either comprise a substrate, an anode on the substrate and a cathode on the anode or comprise a substrate, a cathode on the substrate and an anode on the cathode (a so-called inverted multilayer structure). Between these electrodes there are interleaved at least one charge transporting layer and at least one light emitting layer, with a protective layer as the uppermost layer. It is here noted that the charge transporting layer may be dispensed with. The cathode is made up of a metal or alloy having a low work function, which is formed as a film by the sputtering process, as mentioned above, and the anode is made up of tin-doped indium oxide (ITO), zinc-doped indium oxide (IZO), ZnO, SnO₂, In₂O₃ or the like which is formed as a film by the sputtering process, as again mentioned above.

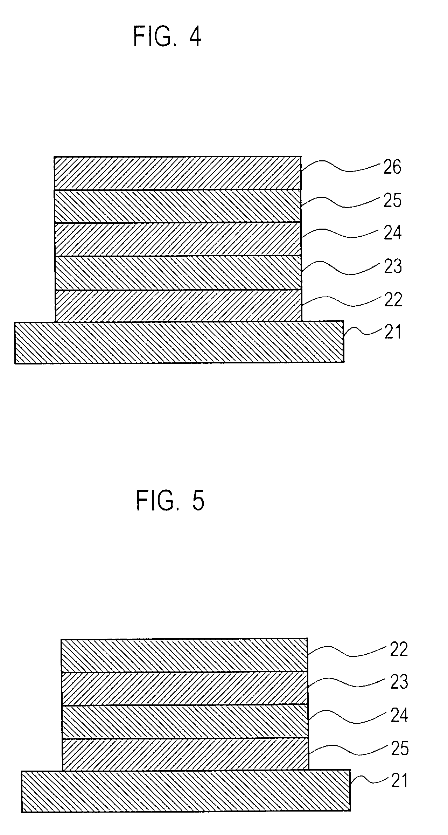

Two preferred embodiments of the organic light emitting device produced by the process of the invention are shown in Figs. 4 and 5. The EL device of Fig. 4 comprises on a substrate 21 an anode 22, a hole injecting and transporting layer 23, a light emitting and electron injecting and transporting layer 24, a cathode 25, and a protective layer 26 in the described order. The EL device of Fig. 5 has a multilayer structure obtained by the inversion of the structure of Fig. 4, and so comprises on a substrate 21 a cathode 25, a light emitting and electron injecting and transporting layer 24, a hole injecting and transporting layer 23, and an anode 22 in the described order.

The organic EL device of the invention is not limited to the structures illustrated, and so may have various structures. For instance, the light emitting layer may be provided in a single layer form and between this light emitting layer and a metal electrode there may be interleaved an electron injecting and transporting layer. If required, the hole injecting and transporting layer 23 may be mixed with the light emitting layer.

If necessary, organic layers such as the cathode or anode or the light emitting layer may be patterned by device separation patterning, mask evaporation or film formation followed by etching whereby a desired light emitting pattern is obtained. In addition, if thin film transistors (TFT) are privided on the substrate, it is then possible to form the respective layers in accordance with the pattern of TFT for immediate displaying or driving purposes.

After electrode formation, the aforesaid protective film and/or other protective layer formed of aluminum or other metal material, SiOx or other inorganic material or Teflon or other organic material may be formed over the device. If the device is designed such that the emitted light is taken out of the side of substrate 1, the protective film or films may be transparent or opaque. If the device has the aforesaid inverted multilayer structure, the protective film or films must be transparent. To make the protective film transparent may be achieved either by selective use of a transparent material such as SiO₂ or controlling film thickness such that it transmits at least 70% of light emission. In general, the protective film has a thickness of the order of 50 to 1,200 nm. The protective film may be formed either by the aforesaid reactive sputtering process or conventional processes such as general sputtering, evaporation or like other processes.

It is here noted that when patterning is performed after cathode formation in the production process of an organic EL device, it is required to remove the cathode from the device in the atmosphere. This, in turn, causes oxidation of the surface of the cathode, resulting in an electron injection efficiency drop or dark spots. It is thus preferable to remove the oxide layer by reverse sputtering (where the surface of the cathode is sputtered) under reduced pressure. Thus, the surface of the cathode is subjected to reverse sputtering thereby removing the oxide layer at a thickness of usually about 2 to 3 nm.

It is preferred to form a sealing layer on the device in order to prevent oxidation of the organic and electrode layers. The sealing layer for preventing penetration of moisture may be formed by bonding sealing plates such as glass plates with moisture-proof adhesive resin layers such as commercially available sheets of photo-curable adhesives, epoxy adhesives, silicone adhesives, and crosslinking ethylene-vinyl acetate copolymer adhesives. Instead of the glass plates, plates of transparent materials such as plastic plates may also be used.

Next, the organic layer provided in the EL device of the invention is explained.

The light emitting layer has functions of injecting holes and electrons, transporting them, and recombining holes and electrons to create excitons. For the light emitting layer, it is preferable to use a relatively electronically neutral compound.

The hole injecting and transporting layer has functions of facilitating injection of holes from the anode, providing stable transportation of holes and blocking electrons, and the electron injecting and transporting layer has functions of facilitating injection of electrons from the cathode, providing stable transportation of electrons and blocking holes. These layers are effective for increasing the number of holes and electrons injected into the light emitting layer and confining holes and electrons therein for optimizing the recombination region to improve light emission efficiency.

The thickness of the light emitting layer, the hole injecting and transporting layer, and the electron injecting and transporting layer is not critical and varies with a particular formation technique although it is usually of the order of preferably 5 to 500 nm, and especially 10 to 300 nm.

The thickness of the hole injecting and transporting layer, and the electron injecting and transporting layer is equal to, or about 1/10 times to about 10 times as large as, the thickness of the light emitting layer although it depends on the design of the recombination/light emitting region. When the electron or hole injecting and transporting layer is separated into an injecting layer and a transporting layer, it is preferable that the injecting layer is at least 1 nm thick and the transporting layer is at least 2 nm thick. The upper limit to thickness is usually about 500 nm for the injecting layer and about 500 nm for the transporting layer. The same film thickness applies when two injecting and transporting layers are provided.

In the organic EL device according to the invention, the light emitting layer contains a fluorescent material that is a compound capable of emitting light. The fluorescent material used herein, for instance, may be at least one compound selected from compounds such as those disclosed in JP-A 63-264692, for instance, quinacridone, rubrene, and styryl dyes. Use may also be made of quinoline derivatives such as metal complex dyes containing 8-quinolinol or its derivative as ligands, for instance, tris(8-quinolinolato) aluminum, tetraphenylbutadiene, anthracene, perylene, coronene, and 12-phthaloperinone derivatives. Use may further be made of phenyanthracene derivatives disclosed in JP-A 6-110569, and tetraarylethene derivatives disclosed in JP-A 6-114456.

Preferably, the fluorescent compound is used in combination with a host substance capable of emitting light by itself; that is, it is preferable that the fluorescent compound is used as a dopant. In such a case, the content of the fluorescent compound in the light emitting layer is in the range of 0.01 to 10% by weight, and especially 0.1 to 5% by weight. By using the fluorescent compound in combination with the host substance, it is possible to vary the wavelength performance of light emission, thereby making light emission possible on a longer wavelength side and, hence, improving the light emission efficiency and stability of the device.

Quinolinolato complexes, and aluminum complexes containing 8-quinolinol or its derivatives as ligands are preferred for the host substance. Such aluminum complexes are typically disclosed in JP-A's 63-264692, 3-255190, 5-70733, 5-258859, 6-215874, etc.

Exemplary aluminum complexes include tris(8-quinolinolato)aluminum, bis(8-quinolinolato)magnesium, bis(benzo{f}-8-quinolinolato)zinc, bis(2-methyl-8-quinolinolato)aluminum oxide, tris(8-quinolinolato)indium, tris(5-methyl-8-quinolinolato)aluminum, 8-quinolinolatolithium, tris(5-chloro-8-quinolinolato)gallium, bis(5-chloro-8-quinolinolato)calcium, 5,7-dichloro-8-quinolinolato-aluminum, tris(5,7-dibromo-8-hydroxyquinolinolato)aluminum, and poly[zinc(II)-bis (8-hydroxy-5-quinolinyl)methane].

Use may also be made of aluminum complexes containing other ligands in addition to 8-quinolinol or its derivatives, for instance, bis(2-methyl-8-quinolinolato) (phenolato) aluminum (III), bis(2-methyl-8-quinolinolato)(o-cresolato) aluminum (III), bis(2-methyl-8-quinolinolato)(m-cresolato) aluminum (III), bis(2-methyl-8-quinolinolato)(p-cresolato) aluminum (III), bis(2-methyl-8-quinolinolato)(o-phenylphenolato)aluminum (III), bis(2-methyl-8-quinolinolato) (m-phenylphenolato)aluminum (III), bis(2-methyl-8-quinolinolato)(p-phenylphenolato)aluminum (III), bis (2-methyl-8-quinolinolato)(2,3-dimethylphenolato)aluminum (III), bis(2-methyl-8-quinolinolato)(2,6-dimethylphenolato)aluminum (III), bis(2-methyl-8-quinolinolato)(3,4-dimethylphenolato) aluminum (III), bis(2-methyl-8-quinolinolato)(3,5-dimethyl-phenolato)aluminum (III), bis(2-methyl-8-quinolinolato) (3,5-di-tert-butylphenolato)aluminum (III), bis(2-methyl-8-quinolinolato) (2,6-diphenylphenolato)aluiminum (III), bis(2-methyl-8-quinolinolato) (2,4,6-triphenylphenolato)aluminum (III), bis(2-methyl-8-quinolinolato)(2,3,6-trimethylphenolato)aluminum (III), bis(2-methyl-8-quinolinolato) (2,3,5,6-tetramethylphenolato)aluminum (III), bis(2-methyl-8-quinolinolato)(1-naphtholato)aluminum (III), bis(2-methyl-8-quinolinolato) (2-naphtholato)aluminum (III), bis(2,4-dimethyl-8-quinolinolato)(o-phenyl-phenolato)aluminum (III), bis(2,4-dimethyl-8-quinolinolato) (p-phenylphenolato)aluminum (III), bis(2,4-dimethyl-8-quinolinolato) (m-phenylphenolato) aluminum (III), bis(2,4-dimethyl-8-quinolinolato)(3,5-dimethylphenolato)aluminum, (III), bis(2,4-dimethyl-8-quinolinolato) (3,5-di-tert-butylphenolato)aluminum (III), bis(2-methyl-4-ethyl-8-quinolinolato) (p-cresolato)aluminum (III), bis(2-methyl-4-methoxy-8-quinolinolato) (p-phenylphenolato)aluminum (III), bis(2-methyl-5-cyano-8-quinolinolato) (o-cresolato)aluminum (III), and bis(2-methyl-6-trifluoromethyl-8-quinolinolato) (2-naphtholato)aluminum (III).

Besides, use may be made of bis(2-methyl-8-quinolinolato)aluminum (III)-µ-oxo-bis(2-methyl-8-quinolinolato) aluminum (III), bis(2,4-dimethyl-8-quinolinolato)aluminum (III)-µ-oxo-bis(2,4-dimethyl-8-quinolinolato)aluminum (III), bis(4-ethyl-2-methyl-8-quinolinolato)aluminum (III)-µ-oxo-bis(4-ethyl-2-methyl-8-quinolinolato)aluminum (III), bis(2-methyl-4-methoxyquinolinolato)aluminum (III)-µ-oxo-bis(2-methyl-4-methoxyquinolinolato)aluminum (III), bis(5-cyano-2-methyl-8-quinolinolato)aluminum (III)-µ-oxo-bis(5-cyano-2-methyl-8-quinolinolato)aluminum (III), bis(2-methyl-5-trifluoromethyl-8-quinolinolato)aluminum (III)-µ-oxo-bis(2-methyl-5-trifluoromethyl-8-quinolinolato)aluminum (III), etc.

Other preferable host substances include phenylanthracene derivatives disclosed in JP-A 6-110569, tetraarylethene derivatives disclosed in JP-A 6-114456, etc.

In the practice of the invention, the light emitting layer may also serve as an electron injecting and transporting layer. In this case, it is preferable to use tris(8-quinolinolato)aluminum or the like, which may be provided by evaporation.

If necessary or preferably, the light emitting layer is formed of a mixed layer of at least one compound capable of injecting and transporting holes with at least one compound capable of injecting and transporting electrons. Preferably in this case, a dopant is incorporated in this mixed layer. The content of the dopant compound in the mixed layer is in the range of 0.01 to 20% by weight, and preferably 0.1 to 15% by weight.

In the mixed layer with a hopping conduction path available for carriers, each carrier migrates in the polarly prevailing substance, so making the injection of carriers having an opposite polarity unlikely to occur. This leads to an increase in the service life of the device due to less damage to the organic compound. By incorporating the aforesaid dopant in such a mixed layer, it is possible to vary the wavelength performance of light emission that the mixed layer itself possesses, thereby shifting the wavelength of light emission to longer wavelengths and improving the intensity of light emission, and the stability of the device as well.

The compound capable of injecting and transporting holes and the compound capable of injecting and transporting electrons, both used to form the mixed layer, may be selected from compounds for the injection and transportation of holes and compounds for the injection and transportation of electrons, as will be described later. Especially for the compounds for the injection and transportation of holes, it is preferable to use amine derivatives having strong fluorescence, for instance, hole transporting materials such as triphenyldiamine derivatives, styrylamine derivatives, and amine derivatives having an aromatic fused ring.

For the compounds capable of injecting and transporting electrons, it is preferable to use metal complexes containing quinoline derivatives, especially 8-quinolinol or its derivatives as ligands, in particular, tris(8-quinolinolato) aluminum (Alq³). It is also preferable to use the aforesaid phenylanthracene derivatives, and tetraarylethene derivatives.

For the compounds for the injection and transportation of holes, it is preferable to use amine derivatives having strong fluorescence, for instance, hole transporting materials such as triphenyldiamine derivatives, styrylamine derivatives, and amine derivatives having an aromatic fused ring, as already mentioned.

In this case, the ratio of mixing the compound capable of injecting and transporting holes with the compound capable of injecting and transporting electrons is determined while taking into account the carrier mobility and carrier density. In general, however, it is preferred that the ratio between the compound capable of injecting and transporting holes and the compound capable of injecting and transporting electrons is of the order of 1/99 to 99/1, particularly 10/90 to 90/10, and more particularly 20/80 to 80/20.

The thickness of the mixed layer must correspond to the thickness of a single molecular layer, and so is preferably less than the thickness of the organic compound layer. More specifically, the mixed layer has a thickness of preferably 1 to 85 nm, especially 5 to 60 nm, and more especially 5 to 50 nm.

Preferably, the mixed layer is formed by co-evaporation where the selected compounds are evaporated from different evaporation sources. When the compounds to be mixed have identical or slightly different vapor pressures (evaporation temperatures), however, they may have previously been mixed together in the same evaporation boat for the subsequent evaporation. Preferably, the compounds are uniformly mixed together in the mixed layer. However, the compounds in an archipelagic form may be present in the mixed layer. The light emitting layer may be formed at a given thickness by the evaporation of the organic fluorescent substance or coating a dispersion of the organic fluorescent substance in a resin binder.

For the hole injecting and transporting layer, use may be made of various organic compounds as disclosed in JP-A's 63-295695, 2-191694, 3-792, 5-234681, 5-239455, 5-299174, 7-126225, 7-126226 and 8-100172 and EP 0650955A1. Examples are tetraarylbenzidine compounds (tetraaryldiamine or triphenyldiamine (TPD)), aromatic tertiary amines, hydrazone derivatives, carbozole derivatives, triazole derivatives, imidazole derivatives, oxadiazole derivatives having an amino group, and polythiophenes. Where these compounds are used in combination of two or more, they may be stacked as separate layers, or otherwise mixed.

When the hole injecting and transporting layer is provided as a separate hole injecting layer and a separate hole transporting layer, two or more compounds are selected in a preferable combination from the compounds already mentioned for the hole injecting and transporting layer. In this regard, it is preferred to laminate layers in such an order that a compound layer having a lower ionization potential is disposed contiguous to the anode (ITO, etc.). It is also preferred to use a compound having good thin film forming ability at the anode surface. This order of lamination holds for the provision of two or more hole injecting and transporting layers, and is effective as well for lowering driving voltage and preventing the occurrence of current leakage and the appearance and growth of dark spots. Since evaporation is utilized in the manufacture of devices, films as thin as about 1 to 10 nm can be formed in a uniform and pinhole-free state, which restrains any change in color tone of light emission and a drop of efficiency by reabsorption even if a compound having a low ionization potential and absorption in the visible range is used in the hole injecting layer. Like the light emitting layer and so on, the hole injecting and transporting layer or layers may be formed by evaporating the aforesaid compounds.

For the electron injecting and transporting layer which is provided if necessary, there may be used quinoline derivatives such as organic metal complexes containing 8-quinolinol or its derivatives as ligands, for instance, tris(8-quinolinolato)aluminum, oxadiazole derivatives, perylene derivatives, pyridine derivatives, pyrimidine derivatives, quinoxaline derivative, diphenylquinone derivatives, and nitro-substituted fluorene derivatives. The electron injecting and transporting layer may also serve as a light emitting layer as previously mentioned. Like the light emitting layer, the electron injecting and transporting layer may be formed by evaporation or the like.

Where the electron injecting and transporting layer is a double-layered structure comprising an electron injecting layer and an electron transporting layer, two or more compounds are selected in a preferably combination from the compounds commonly used for electron injecting and transporting layers. In this regard, it is preferred to laminate layers in such an order that a compound layer having a greater electron affinity is disposed contiguous to the cathode. This order of lamination also applies where a plurality of electron injecting and transporting layers are provided.

For the substrate material, transparent or translucent materials such as glass, quartz and resins are used when the emitted light is taken out of the substrate side. The substrate maybe provided with a color filter film, fluorescent material-containing color conversion film or dielectric reflecting film for controlling the color of light emission. When the device has a inverted multilayer structure as mentioned above, the substrate used may be transparent or opaque. For the opaque substrate, a ceramic material or the like may be used.

For the color filter film, a color filter employed with liquid crystal display devices may be used. However, it is preferable to control the properties of the color filter in conformity to the light emitted from the organic EL device, thereby optimizing the efficiency of taking out light emission and color purity.

By using a color filter capable of cutting off extraneous light of such wavelength as absorbed by the EL device material or the fluorescent color conversion layer, it is possible to improve the light resistance of the device and the contrast of what is displayed on the device.

Instead of the color filter, an optical thin film such as a dielectric multilayer film may be used.

The fluorescent color conversion film absorbs light emitted from an EL device and gives out light from the phosphors contained therein for the color conversion of light emission, and is composed of three components, a binder, a fluorescent material and a light absorbing material.

In the practice of the invention, it is basically preferable to use a fluorescent material having high fluorescent quantum efficiency, especially a fluorescent material having strong absorption in an EL light emission wavelength region. Laser dyes are suitable for the practice of the invention. To this end, for instance, it is preferable to use rohodamine compounds, perylene compounds, cyanine compounds, phthalocyanine compounds (including subphthalocyanine compounds, etc.), naphthaloimide compounds, fused cyclic hydrocarbon compounds, fused heterocyclic compounds, styryl compounds, and coumarin compounds.

For the binder, it is basically preferable to make an appropriate selection from materials that do not extinguish fluorescence. It is particularly preferable to use a material that can be patterned by photolithography, printing or the like. It is also preferable to use a material that is not damaged during ITO film formation.

The light absorbing material is used when light is not fully absorbed by the fluorescent material, and so may be dispensed with, if not required. For the light absorbing material, it is preferable to make a selection from materials that do not extinguish fluorescence.

To form the hole injecting and transporting layer, the light emitting layer and the electron injecting and transporting layer, it is preferable to use a vacuum evaporation technique which enables a homogeneous thin film to be obtained. According to the vacuum evaporation process, it is possible to obtain homogeneous thin films in an amorphous state or with a crystal grain diameter of at most 0.1 µm. The use of a thin film having a crystal grain diameter exceeding 0.1 µm results in non-uniform light emission. To avoid this, it is required to increase the driving voltage of the device; however, there is a striking drop of charge injection efficiency.

No particular limitation is imposed on vacuum evaporation conditions. However, an evaporation rate of the order of 0.01 to 1 nm/sec. is preferably applied at a degree of vacuum of up to 10⁻⁵ Torr. It is also preferable to form the layers continuously in vacuum. If the layers are continuously formed in vacuum, high properties are then obtained because the adsorption of impurities on the interface between the adjacent layers can be avoided. Furthermore, the driving voltage of the device can be lowered while the growth and appearance of dark spots are inhibited.

When the vacuum evaporation process is used to form the layers, each containing a plurality of compounds, it is preferable to carry out co-evaporation while boats charged with the compounds are individually placed under temperature control.

The organic EL light emitting device of the invention is generally of the DC drive type while it may be of the AC or pulse drive type. The applied voltage is generally of the order of 2 to 20 volts.

### EXAMPLE

The present invention are explained more specifically with reference to some examples and comparative examples.

### Example 1

In what follows, some examples are given below to explain the invention more illustratively.

An ITO transparent electrode was formed at a thickness of 100 nm on a glass substrate by sputtering, following by patterning. The electrode was ultrasonically washed with neutral detergent, acetone, and ethanol, and then pulled up from boiling ethanol, followed by drying. This transparent electrode was cleaned on its surface with UV/O₃. Subsequently, the electrode was fixed to a substrate holder in a vacuum evaporation system, which was evacuated to a vacuum of 1 x 10⁻⁴ Pa or lower.

With the vacuum kept, 4,4',4''-tris(-N-(3-methylphenyl)-N-phenylamino)triphenylamine (MTDATA) was evaporated on the electrode at a deposition rate of 0.2 nm/sec. to a thickness of 40 nm to form a hole injecting layer. Then, N,N'-diphenyl-m-tolyl-4,4'-diamino-1,1'-biphenyl (TPD) was evaporated at a deposition rate of 0.2 nm/sec. to a thickness of 35 nm to form a hole transporting layer.

With the vacuum still kept, tris(8-quinolinolato) aluminum (Alq³) was evaporated at a deposition rate of 0.2 nm/sec. to a thickness of 50 nm to form an electron injecting and transporting and light emitting layer.

Then, a substrate with the organic EL structure stacked thereon was transferred from the vacuum evaporation system to a sputtering system with opposite targets wherein Mg·Ag alloy (Ag: 10 at%) targets were used to form a cathode to a thickness of 200 nm by means of DC sputtering. The sputtering gas, gas pressure, and power applied were Ar, 1 x 10⁻² Pa, and 2 KW, respectively, with each target size of 100 x 100 mm and a distance of 120 mm from the organic EL structure to the center of each target.

A DC voltage was applied across the organic EL device in a dry argon atmosphere to continuously drive the device at a constant current density of 10 mA/cm². At the initial, the device when driven at 8 volts was found to emit green light at a luminance of 500 cd/m² (light emission maximum wavelength λmax = 520 nm). The half-life of the luminance was 500 hours during which a driving voltage increase of 2 V was observed. Even after the device was driven over 2,000 hours, nowhere in the device were dark spots of 0.1 mm or greater found at all.

### Example 2

In Example 1, a device having 8 x 2 = 16 picture elements or pixels, each of 2 x 2 mm, was prepared by arranging two parallel striped ITO transparent electrodes (anodes) perpendicularly with respect to 8 parallel striped MgAg electrodes (cathodes) and disposing the pixels at an interval of 3 mm. Ten such device sheets or 160 pixels were estimated by means of a tester in terms of current leakage. A device with a resistance of 20 MΩ or lower was used as an estimation criterion. As a result, all the devices were found to be free from leakage.

### Example 3

An organic EL element was prepared according to the production process described in Example 1 with the exception that a cathode and a protective film were formed by the following reactive sputtering process.

A substrate with the organic EL structure stacked thereon was transferred from the vacuum evaporation system to the reactive sputtering system shown in Fig. 2, where Ag·Mg alloy (Ag: 10 at%) targets were used to form a cathode at a film forming rate of 15 nm/min. by DC sputtering. Ar was used as the sputtering gas at a gas pressure of 1 x 10⁻² Pa. Upon a thickness of 200 nm reached, an N₂ gas and an Ar gas were continuously fed from the reactive gas feeding port and the sputtering gas feeding port, respectively, to form a protective film composed of a Mg nitride film having a thickness of 100 nm. In this case, the flow rates of the N₂ gas and Ar gas were 15 sccm and 20 sccm, respectively.

As a result of estimation as in Example 1, the obtained organic EL device was found to be equivalent to that of Example 1 in terms of initial EL properties (light emission luminance and driving voltage) and service life properties (half-life of luminance and driving voltage increase). Even after the device was driven over 3,000 hours, nowhere in the device were dark spots of 0.1 mm or greater found at all.

### Example 4

A glass substrate was ultrasonically washed with neutral detergent, acetone, and ethanol, and then pulled up from boiling ethanol, followed by drying. This glass substrate was cleaned on its surface with UV/O₃. Subsequently, the glass substrate was fixed to a substrate holder in a sputtering system, which was evacuated to a vacuum of 1 x 10⁻⁴ Pa or lower.

With the vacuum kept, Mg·Ag alloy (Ag: 10 at%) targets were used to form a cathode of 200 nm in thickness by DC sputtering. In this case, Ar was used as the sputtering gas at a gas pressure of 1 x 10⁻² Pa. The input power was 2 KW, with each target size of 100 x 100 mm and a distance of 120 mm from the substrate from the center of each target.

Then, the cathode was patterned, and fed back into the sputtering tank which was again evacuated. Thereafter, the cathode was subjected to reverse sputtering to remove an oxide film from its surface. With the vacuum kept, the cathode was transferred to the vacuum evaporation system which was again evacuated to 1 x 10⁻⁴ Pa or lower. With the vacuum kept, tris(8-quinolinolato)aluminum (Alq³) was evaporated at a deposition rate of 0.2 nm/sec. to a thickness of 50 nm to form an electron injecting and transporting and light emitting layer.

With the vacuum maintained, N,N'-diphenyl-m-tolyl-4,4'-diamino-1,1'-biphenyl (TPD) was then evaporated at a deposition rate of 0.2 nm/sec. to a thickness of 35 nm to form a hole transporting layer.

With the vacuum still maintained, 4,4',4''-tris(-N-(3-methylphenyl)-N-phenylamino)triphenylamine (MTDATA) was evaporated on the electrode at a deposition rate of 0.2 nm/sec. to a thickness of 40 nm to form a hole injecting layer.

With the vacuum still maintained, the organic EL structure was again transferred from the vacuum evaporation system to a sputtering system with opposite targets, where ITO (Sn: 10% by weight) targets were used to form an anode of 100 nm in thickness thereon by means of DC sputtering. In this case, Ar was used as the sputtering gas at a gas pressure of 1 x 10⁻² Pa. The Ar gas was fed at 20 sccm from the sputtering gas feeding port while an O₂ gas was fed at 1 sccm from the reactive gas feeding port. The input power was 2 KW, with each target size of 100 x 100 mm and a distance of 120 mm from the substrate to the center of each target.

A DC voltage was applied across the organic EL device in a dry argon atmosphere to continuously drive the device at a constant current density of 10 mA/cm². At the initial, the device when driven at 8.4 volts was found to emit green light at a luminance of 450 cd/m² (light emission maximum wavelength λmax = 520 nm). The half-life of the luminance was 400 hours during which a driving voltage increase of 2.3 V was observed.

Even when the films were formed in the reverse order, much the same results as in Example 1 could be obtained.

### Example 5

An organic EL device was prepared following Example 1 with the exception that the system shown in Fig. 3 was used. Consequently, much the same results as in Example 1 were obtained.

### Example 6

Organic EL devices were prepared following Example 1 with the exception that instead of the Mg·Ag alloy, Mg·In (In: 10 at%), Al·Ca (Ca: 5 at%) and Al·In (In: 50 at%) alloys were used as the cathode material. Consequently, much the same results as in Example 1 were obtained. Even with cathodes madeup of pure metals Mg, Al and In, the initial EL properties (light emission luminance and driving voltage) and service life properties (half-life of luminance and driving voltage increase) were found to be as preferable as those of Example 1.

### Comparative Example 1

An organic EL device was prepared according to the production process for an organic EL device described in Example 1 with the exception that an Mg·Ag (with a weight ratio of 10:1) cathode was fabricated by co-evaporation in vacuum.

The obtained organic EL device was estimated as in Example 1. As a result, the initial EL properties (light emission luminance and driving voltage) and service life properties (half-life of luminance and driving voltage increase) were found to be equivalent to those of Example 1. After a 500-hour driving, however, the appearance and growth of dark spots of 0.1 mm or greater were observed.

### Comparative Example 2

Organic EL devices were prepared following Example 2 with the exception that a cathode was made by the following process.

A substrate with an organic EL device structure stacked thereon was transferred from a vacuum evaporation system to a magnetron sputtering system where a target having the same composition as in Example 1 was used to form a cathode of 200 nm in thickness by DC sputtering. In this case, Ar was used as the sputtering gas at a gas pressure of 1 Pa. The input power was 100 W, with a target diameter of 4 inches and a distance of 90 mm from the organic EL device structure to the center of the target.

The obtained organic EL devices were estimated as in Example 1. About 92% (147/160) caused leakage.

DC voltages were applied across the leakage-free organic EL devices in a dry argon atmosphere to continuously drive the devices at a constant current density of 10 mA/cm². As a result, the initial EL properties became worse, as expressed by a light emission luminance of 350 cd/m² at a driving voltage of 9 V.

As described above, the present invention provides an organic EL device production process which makes it possible to produce an organic EL device that is improved in terms of the adhesion of an electrode to an organic layer at an interface therebetween, has an ever longer service life and presents high-quality displays, and which causes less physical damage to films forming an organic EL element.

Japanese Patent Application No. 74553/1997 is herein incorporated by reference.

Although some preferred embodiments have been described, many modifications and variations may be made thereto in the light of the above teachings. It is therefore to be understood that within the scope of the appended claims, the invention may be practiced otherwise than as specifically described.

## Claims

1. A process for producing an organic electroluminescent light emitting device by providing a sputtering system with opposite targets, which comprises a pair of targets positioned in parallel opposition to each other with a given space located therebetween, magnetic field generating means for generating a magnetic field in a substantially vertical direction with respect to surfaces of said targets, and shield means located at such positions as to cover portions of said targets except opposite surfaces thereof, with a substrate positioned in opposition to said space between said targets, and applying a given voltage between said targets and said shield means, so that an electrode is provided on an organic electroluminescent light emitting structure formed on said substrate by a sputtering technique.

2. A production process for an organic electroluminescent light emitting device, wherein a cathode is formed by the sputtering technique recited in claim 1, and sputtering is then carried out by introducing a reactive gas to form a protective film on said cathode.

3. The production process of claim 2, wherein a sputtering gas is fed from the vicinity of the target that is not opposite to said substrate while said reactive gas is fed from the vicinity of a surface of said substrate on which a film is formed.
